# EUROPEAN PATENT APPLICATION

(11) **EP 4 773 619 A1**
(43) Date of publication of application: **08.07.2026**
(21) Application number: 24860354.0
(22) Date of filing: 26.08.2024
(51) Int. Cl.: H04N 23/68, H04N 23/54, H04N 23/55, H05K 1/18

(54) **CAMERA APPARATUS AND OPTICAL DEVICE**

(30) Priority: 30.08.2023 KR 20230114939; 06.08.2024 KR 20240104697
(71) Applicant: LG Innotek Co., Ltd., Seoul 07796 (KR)
(72) Inventor: LEE, Jun Taek, Seoul 07796 (KR)
(74) Representative: DREISS Patentanwälte PartG mbB
(86) International application number: PCT/KR2024/012714
(87) International publication number: WO 2025/048434

(57) **Abstract**

The present embodiment relates to a camera apparatus comprising: a fixed part; a housing movably disposed on the fixed part; a carrier disposed in the housing; a first coil for moving the carrier in an optical axis direction; a second coil for moving the housing in the direction perpendicular to the optical axis direction; a magnet interacting with any one or more among the first coil and the second coil; and an image sensor moving integrally with the carrier.

## Description

### [Technical Field]

The present embodiment relates to a camera device and an optical device.

### [Background Art]

The camera devices are devices that capture images or videos of subjects, and are installed in optical devices such as smartphones, drones, and vehicles.

The cameras devices feature an autofocus function that automatically adjusts focus based on the distance to the subject. The cameras devices also feature optical image stabilization to prevent focus fluctuations caused by user's hand tremors.

However, recent advancements in high-resolution image sensors and larger lens diameters have led to increased lens weight, making it difficult to secure the electromagnetic force necessary to move the lens for autofocus and optical image stabilization functions.

(Patent Document 1) US 2013-0016427 A1

### [Disclosure]

### [Technical Problem]

An object of the present embodiment is to provide a camera device in which a heavy lens is fixed and a relatively lightweight image sensor moves to perform an autofocus function and an optical image stabilization function.

### [Technical Solution]

According to the present embodiment, a camera device may comprise a fixed part; a housing movably disposed on the fixed part; a carrier disposed within the housing; a first coil configured to move the carrier in the optical axis direction; a second coil configured to move the housing in a direction perpendicular to the optical axis direction; a magnet configured to interact with at least one of the first coil and the second coil; and an image sensor configured to move integrally with the carrier.

The camera device may further comprise a lens coupled to the fixed part, in which, when current is applied to the first coil, the lens may be fixed and the image sensor may move in the optical axis direction.

When current is applied to the second coil, the lens may be fixed and the image sensor may move in the direction perpendicular to the optical axis direction.

The magnet may overlap with the first coil and the second coil in the direction perpendicular to the optical axis direction and be disposed between the first coil and the second coil.

The camera device may further comprise a first elastic member coupled to the housing and the carrier.

The camera device may further comprise a second elastic member coupled to the housing; and a wire having one end portion coupled to the fixed part and the other end portion coupled to the second elastic member.

The camera device may further comprise a first substrate electrically connected to the image sensor and movably supporting the image sensor.

The first substrate may comprise a sensor disposition part, a terminal part disposed outside the sensor disposition part, and a connection part connecting the sensor disposition part and the terminal part, and the connection part may comprise a shape that is bent a plurality of times.

The connection part may comprise a first bent part that is bent about an virtual first bending axis, and a second bent part that is bent about an virtual second bending axis, the first bending axis may be disposed parallel to the optical axis, and the second bending axis may be disposed perpendicular to the optical axis.

The camera device may further comprise a second substrate coupled to the lower surface of the sensor disposition part of the first substrate and comprising a hole; and a stiffener coupled to the lower surface of the second substrate, in which the image sensor may be coupled to the upper surface of the stiffener and disposed in the hole of the first substrate.

The first coil may be disposed on the carrier, and the magnet may be disposed on the housing.

The camera device may comprise a lens, and the fixing part may comprise an upper cover coupled to the lens and a lower cover coupled to the upper cover, and the second coil may be disposed on the upper cover.

The camera device may comprise a ball disposed between the upper cover and the housing.

The upper cover may comprise a terminal coupled to the second coil and a conductive line connected to the terminal.

According to the present embodiment, an optical device may comprise a main body; the camera device disposed on the main body; and a display disposed on the main body and configured to output at least one of an image and a video captured by the camera device.

### [Advantageous Effect]

Through the present embodiment, a heavy lens can be fixed in place while a relatively lightweight image sensor moves to perform autofocus and optical image stabilization functions.

Therefore, even when the lens diameter and weight increase, autofocus and optical image stabilization functions can be performed smoothly.

Furthermore, the power consumption during autofocus and optical image stabilization can be reduced.

Furthermore, the size of the coils and magnets for autofocus and optical image stabilization functions can be reduced, resulting in a more compact camera device. Consequently, the height of the camera device protruding from the smartphone can be minimized or eliminated.

Furthermore, since the lens is fixed, a structure can be provided that facilitates installation of an aperture between a plurality of lenses.

### [Description of Drawings]

FIG. 1 is a perspective view illustrates a camera device according to the present embodiment.
FIG. 2 is a cross-sectional perspective view taken along line A-A of FIG. 1.
FIG. 3 is an exploded perspective view illustrates a camera device according to the present embodiment.
FIG. 4 is a perspective view illustrates an autofocus assembly of a camera device according to the present embodiment.
FIG. 5 is a perspective view illustrates an image sensor assembly of a camera device according to the present embodiment.
FIG. 6 is a perspective view of FIG. 5, additionally illustrating a carrier and an AF coil.
FIG. 7 is a perspective view of FIG. 6, additionally illustrating a housing and a magnet.
FIG. 8 is a perspective view of FIG. 7, additionally illustrating an upper elastic member.
FIG. 9 is a perspective view illustrates an optical image stabilization assembly according to the present embodiment.
FIG. 10 is a perspective view illustrating a portion of a camera device according to the present embodiment.
FIG. 11 is a bottom perspective view illustrating an upper cover and an OIS coil of a camera device according to the present embodiment.
FIG. 12 is a bottom perspective view of FIG. 11, additionally illustrating the housing, magnet, lower elastic member, and wire.
FIG. 13 is an exploded perspective view of FIG. 12.
FIG. 14 is a bottom perspective view of FIG. 12, additionally illustrating the carrier.
FIG. 15 is a bottom perspective view illustrating a camera device according to the present embodiment with the lower cover removed.
FIG. 16 is a bottom perspective view illustrating the upper cover of the camera device according to the present embodiment.
FIG. 17 is a perspective view illustrating a driving part of the camera device according to the present embodiment.
FIG. 18 is a cross-sectional view illustrating the disposition structure of a ball of a camera device according to a modified example.
FIG. 19 is a bottom perspective view illustrating a ball and related components of a camera device according to a modified example.
FIG. 20 is a diagram illustrating the operation of a camera device according to the present embodiment.
FIG. 21 is a perspective view illustrating an optical device according to the present embodiment.

### [Best Mode]

Hereinafter, preferred embodiments of the present disclosure will be described in detail with reference to the attached drawings.

However, the technical idea of the present disclosure is not limited to some of the embodiments described, but can be implemented in various different forms, and within the scope of the technical idea of the present disclosure, one or more of the components between the embodiments can be selectively combined or substituted and used.

In addition, terms (comprising technical and scientific terms) used in the present embodiment can be interpreted as meanings that can be generally understood by a person having ordinary knowledge in the technical field to which the first embodiment belongs, unless explicitly and specifically defined and described, and terms that are commonly used, such as terms defined in a dictionary, can be interpreted in consideration of the contextual meaning of the related technology.

In addition, terms used in the present embodiment are used to describe the embodiments and are not intended to limit the present disclosure.

In this specification, the singular may also comprise the plural unless specifically stated otherwise in the phrase, and when it is described as "at least one (or one or more) of A, B, C", it may comprise one or more of all combinations that can be combined with A, B, C.

In addition, in describing components of the first embodiment, terms such as first, second, A, B, (A), (B), or the like may be used. These terms are only intended to distinguish the components from other components, and are not intended to limit the nature, order, or sequence of the components.

In addition, when a component is described as being 'connected', 'coupled', or 'accessed' to another component, it may comprise not only cases where the component is 'connected', 'coupled', or 'accessed' directly to the other component, but also cases where the component is 'connected', 'coupled', or 'accessed' by another component between the component and the other component.

In addition, when described as being formed or disposed "above" or "below" each component, "above" or "below" comprises not only the case where the two components are in direct contact with each other, but also the case where one or more other components are formed or disposed between the two components. In addition, when expressed as "above" or "below", the meaning of the downward direction as well as the upward direction based on one component may be comprised.

An "optical axis direction" used below is defined as an optical axis direction of the lens and/or image sensor of a camera device.

The "vertical direction" used below may be parallel to or the same direction as the optical axis direction. The vertical direction may correspond to the "z-axis direction." The "horizontal direction" used below may be a direction perpendicular to the vertical direction. In other words, the horizontal direction may be a direction perpendicular to the optical axis. Therefore, the horizontal direction may comprise the "x-axis direction" and the "y-axis direction."

The "auto focus (AF) function" used below is defined as a function that automatically focuses on a subject by adjusting the distance between the image sensor and the lens by moving the image sensor in the optical axis direction according to the distance to the subject so that a clear video of the subject can be obtained on the image sensor. Additionally, "optical image stabilization feedback (OISF) control" is defined as feedback controlling the position of the image sensor in real time by detecting the distance between the image sensor and the lens to improve the accuracy of focus adjustment.

The "optical image stabilization (OIS) function" used below is defined as a function that moves or tilts the image sensor in a direction perpendicular to the optical axis to compensate for hand tremors, thereby preventing images or videos from shaking due to the user's hand tremors. Furthermore, the "optical image stabilization (OIS) feedback control" is defined as detecting the position of the image sensor relative to the lens and providing real-time feedback control of the image sensor's position to improve the accuracy of optical image stabilization.

Hereinafter, one of the "sensor substrate 610" and the "support substrate 640" may be referred to as the "first substrate," and the other may be referred to as the "second substrate."

Hereinafter, one of the "AF coil 410" and the "OIS coil 420" may be referred to as the "first coil," and the other may be referred to as the "second coil."

Hereinafter, one of the "upper elastic member 510" and the "lower elastic member 520" may be referred to as the "first elastic member," and the other may be referred to as the "second elastic member."

The configuration of the camera device according to the present embodiment will be described below with reference to the drawings.

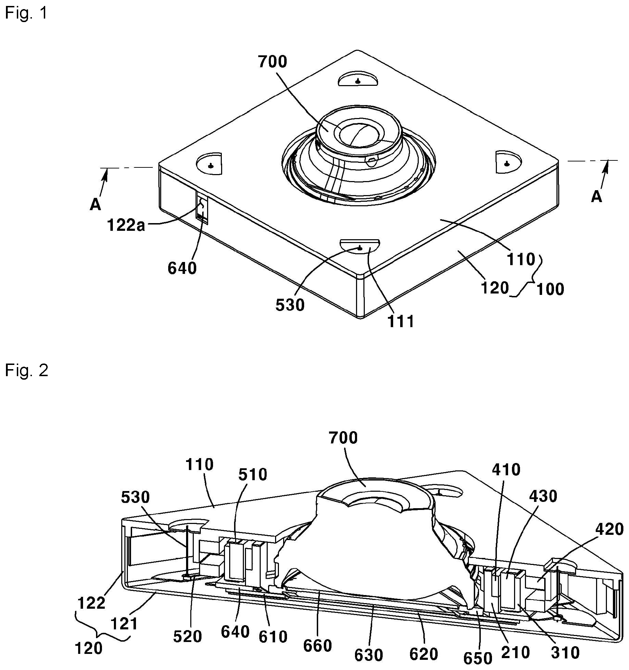

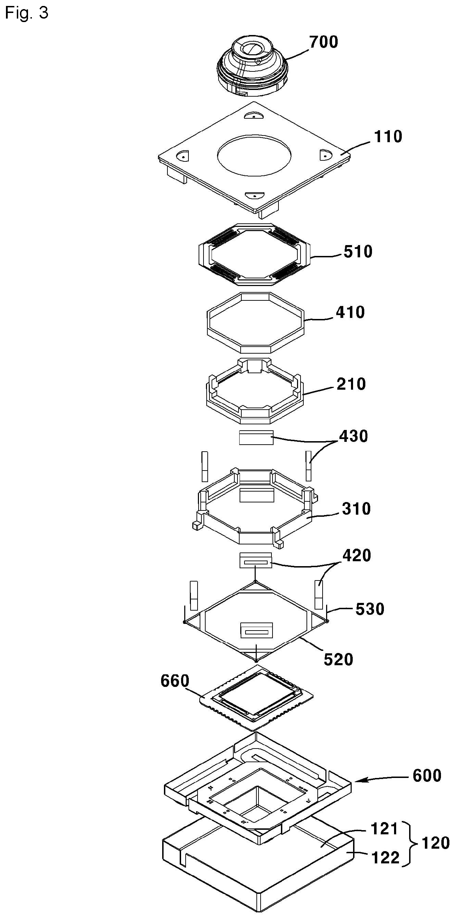

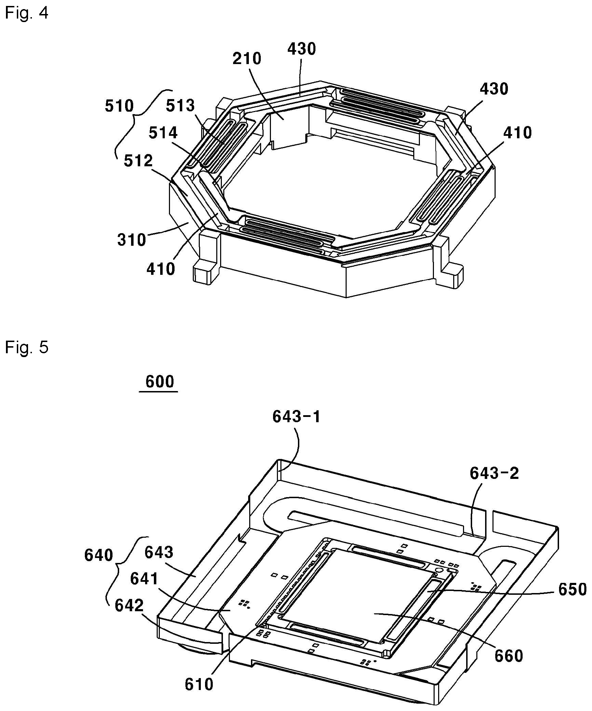

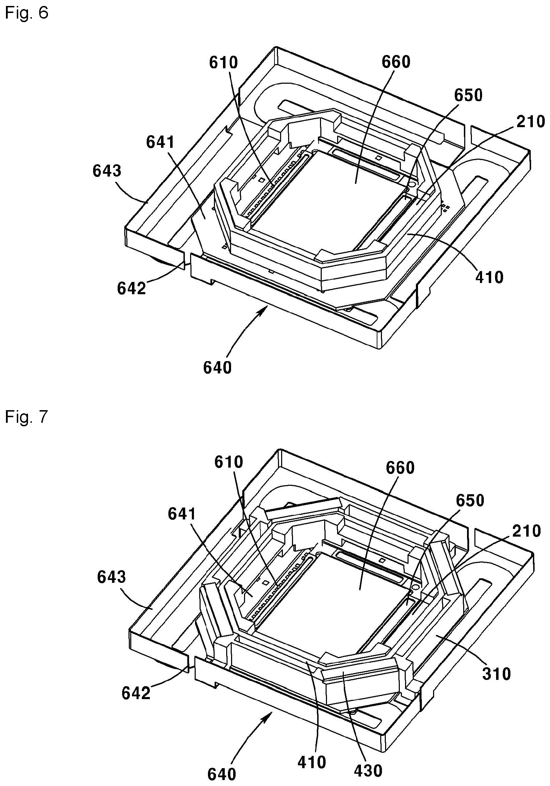

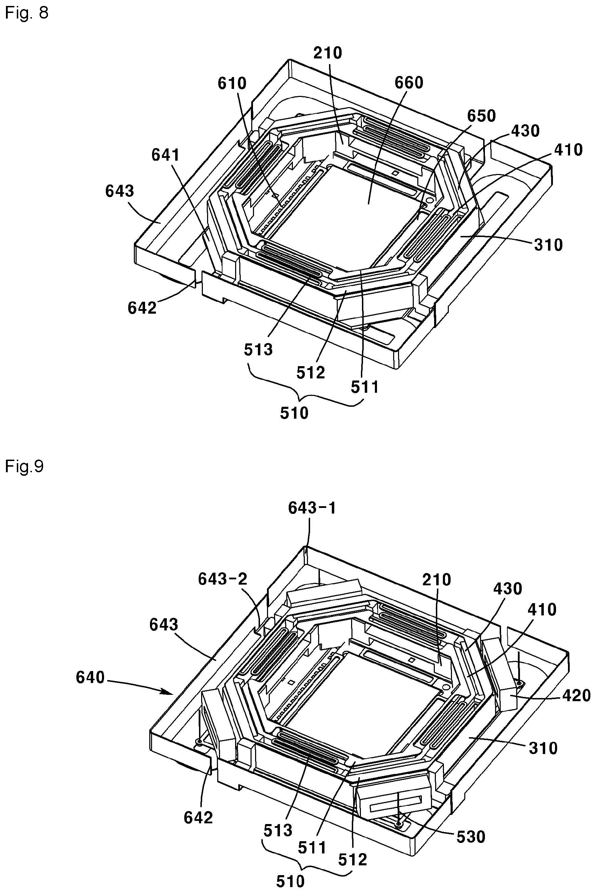

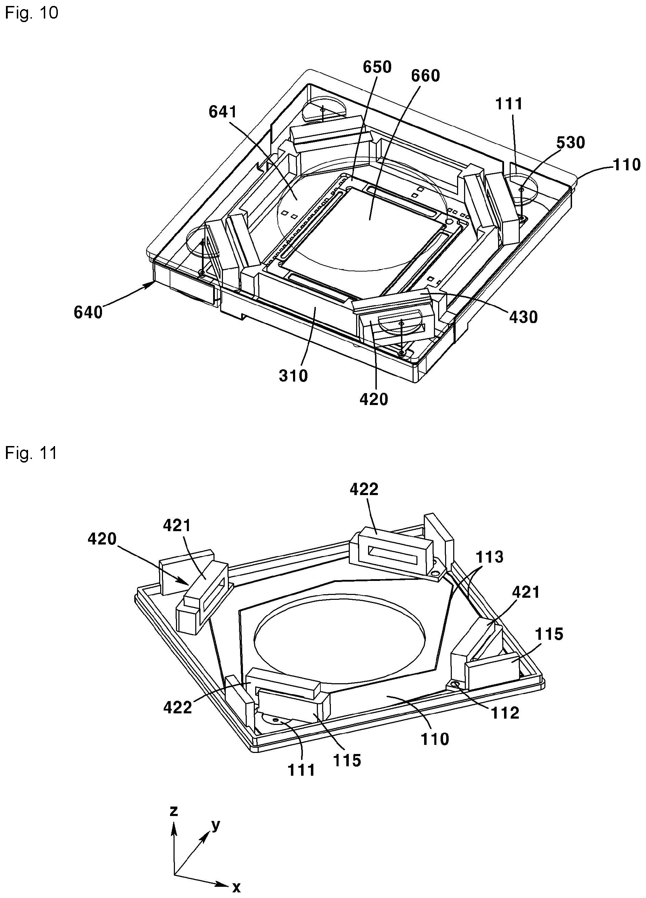

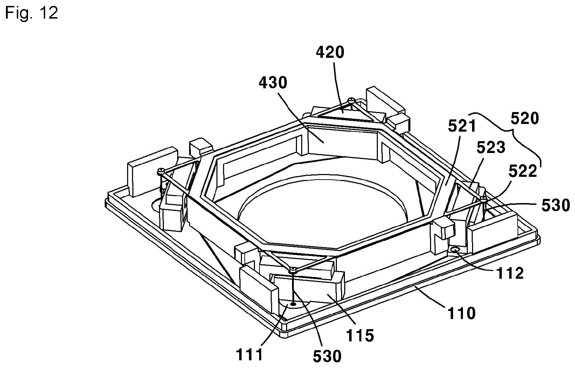

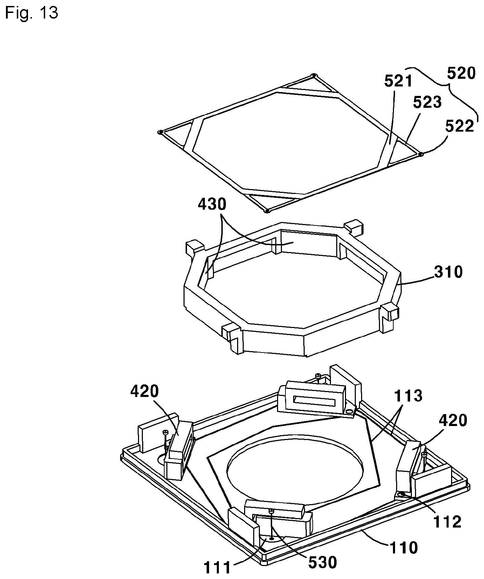

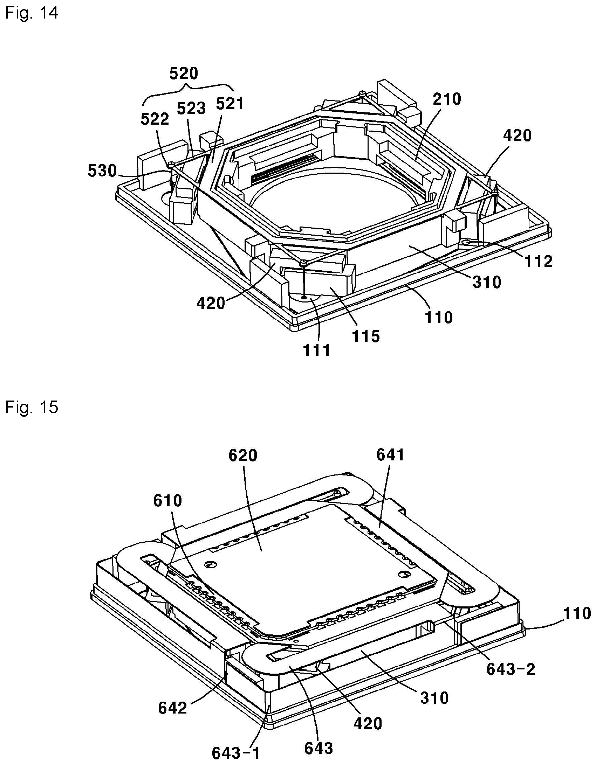

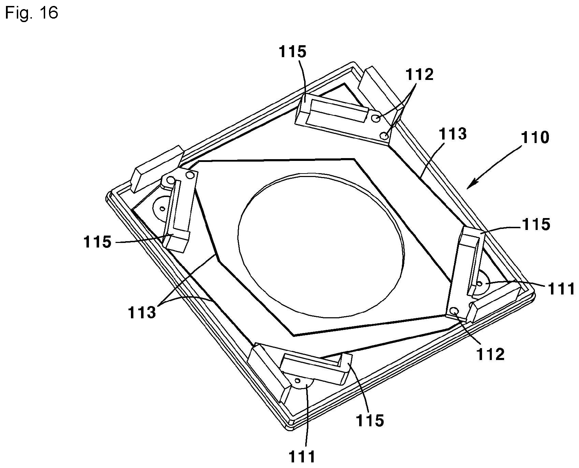

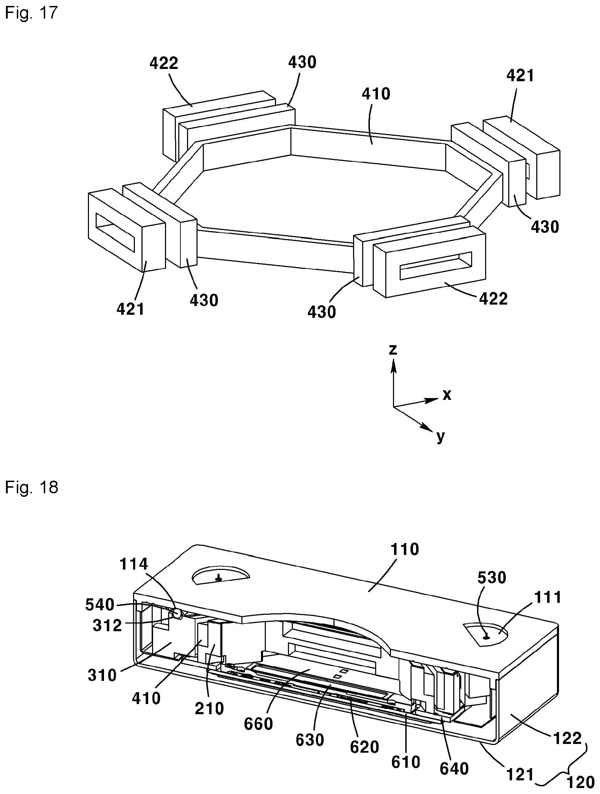

FIG. 1 is a perspective view illustrates a camera device according to the present embodiment. FIG. 2 is a cross-sectional perspective view taken along line A-A of FIG. 1. FIG. 3 is an exploded perspective view illustrates a camera device according to the present embodiment. FIG. 4 is a perspective view illustrates an autofocus assembly of a camera device according to the present embodiment. FIG. 5 is a perspective view illustrates an image sensor assembly of a camera device according to the present embodiment. FIG. 6 is a perspective view of FIG. 5, additionally illustrating a carrier and an AF coil. FIG. 7 is a perspective view of FIG. 6, additionally illustrating a housing and a magnet. FIG. 8 is a perspective view of FIG. 7, additionally illustrating an upper elastic member. FIG. 9 is a perspective view illustrates an optical image stabilization assembly according to the present embodiment. FIG. 10 is a perspective view illustrating a portion of a camera device according to the present embodiment. FIG. 11 is a bottom perspective view illustrating an upper cover and an OIS coil of a camera device according to the present embodiment. FIG. 12 is a bottom perspective view of FIG. 11, additionally illustrating the housing, magnet, lower elastic member, and wire. FIG. 13 is an exploded perspective view of FIG. 12. FIG. 14 is a bottom perspective view of FIG. 12, additionally illustrating the carrier. FIG. 15 is a bottom perspective view illustrating a camera device according to the present embodiment with the lower cover removed. FIG. 16 is a bottom perspective view illustrating the upper cover of the camera device according to the present embodiment. FIG. 17 is a perspective view illustrating a driving part of the camera device according to the present embodiment.

The camera device 10A may comprise a camera module. The camera device 10A may comprise an image sensor driving device. The camera device 10A may comprise an actuator. The camera device 10A may comprise an autofocus device. The camera device 10A may comprise an optical image stabilization device.

The camera device 10A may comprise a fixed part 100. The fixed part 100 may be a relatively fixed portion during autofocus operation. The fixed part 100 may be a relatively fixed portion during optical image stabilization operation.

The camera device 10A may comprise an upper cover 110. The fixed part 100 may comprise an upper cover 110. The upper cover 110 may comprise a base. The upper cover 110 may be formed as an injection molded product. The upper cover 110 may be coupled to a lens. The upper cover 110 can be coupled to the OIS coil 420. The upper cover 110 can be disposed on the lower cover 120. The upper cover 110 can be disposed on the lower cover 120.

The upper cover 110 may comprise a substrate 111. The substrate 111 may be understood as a separate component from the upper cover 110. The substrate 111 may be disposed on the upper cover 110. The substrate 111 may be coupled to a wire 530. The substrate 111 may comprise a hole through which the wire 530 passes. The substrate 111 may comprise a terminal coupled to the wire 530 via solder.

The upper cover 110 may comprise a terminal 112. The terminal 112 may be coupled to the OIS coil 420. The terminal 112 may be disposed on the lower surface of the upper cover 110. The terminal 112 may be formed as an insert on the lower surface of the upper cover 110. The terminal 112 may comprise a plurality of terminals.

The upper cover 110 may comprise a conductive line 113. The conductive line 113 may be connected to a terminal 112. The conductive line 113 may be electrically connected to the terminal 112. The conductive line 113 may connect a plurality of terminals. The conductive line 113 may electrically connect a plurality of terminals. The conductive line 113 may connect terminals that are disposed on opposite sides.

The upper cover 110 may comprise a coil fixing rib 115. An OIS coil 420 may be disposed on the coil fixing rib 115. The coil fixing rib 115 may protrude from the lower surface of the upper cover 110.

The camera device 10A may comprise a lower cover 120. The fixed part 100 may comprise the lower cover 120. The lower cover 120 may be coupled to the upper cover 110. The lower cover 120 may be a shield can. The lower cover 120 may be formed of metal. The lower cover 120 may be disposed on the upper cover 110. The lower cover 120 may be disposed below the upper cover 110.

The lower cover 120 may comprise a lower plate 121. The lower cover 120 may comprise a side plate 122. The side plate 122 may be formed to extend upward from the outer edge of the lower plate 121. The side plate 122 may be formed integrally with the lower plate 121. The side plate 122 may be formed by being bent from the lower plate 121. The side plate 122 may comprise a plurality of side plates. The side plate 122 may comprise four side plates. The side plate 122 may comprise a first side plate and a second side plate disposed opposite each other, and a third side plate and a fourth side plate disposed opposite each other.

The lower cover 120 may comprise a cutout 122a. The cutout 122a may be formed in the side plate 122. A portion of the support substrate 640 can be pulled outward from the camera device 10A through the cut part 122a.

The camera device 10A may comprise an autofocus assembly. The autofocus assembly may comprise components that move the image sensor 630 in the optical axis direction.

The camera device 10A may comprise an optical image stabilization assembly. The optical image stabilization assembly may comprise components that move the image sensor 630 in a direction perpendicular to the optical axis.

The camera device 10A may comprise an AF moving part. The AF moving part may move during AF operation. The AF moving part may move relative to a fixed part during AF operation. The AF moving part may move in the optical axis direction.

The camera device 10A may comprise a carrier 210. The AF moving part may comprise the carrier 210. The carrier 210 may be disposed within a housing 310. The carrier 210 may be movably disposed within the housing 310. The carrier 210 can move in the optical axis direction with respect to the housing 310. The carrier 210 can be disposed on the fixed part 100. The carrier 210 can be disposed within the fixed part 100. The carrier 210 can be disposed on the fixed part 100. The carrier 210 can move together with the image sensor 630. When the carrier 210 moves, the image sensor 630 can move together. The carrier 210 can be spaced apart from the lens.

The camera device 10A can comprise an OIS moving part. The OIS moving part can move when the OIS is driven. The OIS moving part can move relative to the fixed part when the OIS is driven. The OIS moving part can move in a direction perpendicular to the optical axis. When the OIS moving part moves, the AF moving part can also move together.

The camera device 10A may comprise a housing 310. The OIS moving part may comprise the housing 310. The housing 310 may be an OIS carrier. The housing 310 may be a holder. The housing 310 may be disposed on the fixed part 100. The housing 310 may be disposed within the fixed part 100. The housing 310 may be disposed on the fixed part 100. The housing 310 may be movably disposed on the fixed part 100. The housing 310 may move in a direction perpendicular to the optical axis direction with respect to the fixed part 100. The housing 310 may move the carrier 210.

The camera device 10A may comprise a driving part. The driving part may move the AF moving part. The driving part may move the OIS moving part. The driving part may comprise an AF driving part that moves the AF moving part. The driving part may comprise an OIS driving part that moves the OIS moving part. Portions of the AF driving part and the OIS driving part may overlap. In other words, some components may be used for both the AF driving and the OIS driving. In the present embodiment, the magnet 430 may be used for both the AF driving and the OIS driving.

The camera device 10A may comprise an AF coil 410. The driving part may comprise the AF coil 410. The AF coil 410 may move the carrier 210 in the optical axis direction. The AF coil 410 may be disposed on the carrier 210. The AF coil 410 may be fixed to the carrier 210. The AF coil 410 may be coupled to the carrier 210. The AF coil 410 may be adhered to the carrier 210. The AF coil 410 can move integrally with the carrier 210. The AF coil 410 can be disposed on the outer peripheral surface of the carrier 210. The AF coil 410 can be formed in a ring shape when viewed in the optical axis direction.

When current is applied to the AF coil 410, the lens 700 is fixed and the image sensor 630 can move in the optical axis direction.

The camera device 10A may comprise an OIS coil 420. The driving part may comprise the OIS coil 420. The OIS coil 420 may move the housing 310 in a direction perpendicular to the optical axis direction. The OIS coil 420 may be disposed on the upper cover 110. The OIS coil 420 may be fixed to the upper cover 110. The OIS coil 420 may be coupled to the upper cover 110. The OIS coil 420 may be adhered to the upper cover 110. The OIS coil 420 may be disposed on the fixed part 100. The OIS coil 420 may be fixed to the fixed part 100. The OIS coil 420 may be coupled to the fixed part 100. The OIS coil 420 may be adhered to the fixed part 100. The OIS coil 420 may be fixed. The OIS coil 420 may be formed in a ring shape when viewed in a direction perpendicular to the optical axis.

When current is applied to the OIS coil 420, the lens 700 is fixed and the image sensor 630 may move in the direction perpendicular to the optical axis direction.

The OIS coil 420 may comprise an OIS-x coil 421. The OIS-x coil 421 may move the magnet 430 in the x-axis direction. The OIS-x coil 421 may move the image sensor 630 in the x-axis direction. The OIS-x coil 421 may comprise a plurality of OIS-x coils. The OIS-x coil 421 may comprise two OIS-x coils. The two OIS-x coils can overlap each other in the x-axis direction.

The OIS coil 420 can comprise an OIS-y coil 422. The OIS-y coil 422 can move the magnet 430 in the y-axis direction. The OIS-y coil 422 can move the image sensor 630 in the y-axis direction. The OIS-y coil 422 can comprise a plurality of OIS-y coils. The OIS-y coil 422 can comprise two OIS-y coils. The two OIS-y coils can overlap each other in the y-axis direction.

The OIS coil 420 may comprise a plurality of coils. The OIS coil 420 may comprise four coils. The OIS coil 420 may comprise two OIS-x coils 421 and two OIS-y coils 422. The two OIS-x coils 421 may be disposed opposite each other. The two OIS-y coils 422 may be disposed opposite each other.

The camera device 10A may comprise a magnet 430. The driving part may comprise a magnet 430. The magnet 430 may be disposed in the housing 310. The magnet 430 may be fixed to the housing 310. The magnet 430 may be coupled to the housing 310. The magnet 430 can be adhered to the housing 310. The magnet 430 can move integrally with the housing 310.

The magnet 430 can interact with the AF coil 410. The magnet 430 can electromagnetically interact with the AF coil 410. The magnet 430 can face the AF coil 410. The magnet 430 can be opposite to AF coil 410. The magnet 430 can correspond to the AF coil 410. The magnet 430 can be disposed at a position corresponding to the AF coil 410.

The magnet 430 can interact with the OIS coil 420. The magnet 430 can electromagnetically interact with the OIS coil 420. The magnet 430 may face the OIS coil 420. The magnet 430 may be opposite to the OIS coil 420. The magnet 430 may correspond to the OIS coil 420. The magnet 430 may be disposed at a position corresponding to the OIS coil 420.

The magnet 430 may overlap the AF coil 410 in a direction perpendicular to the optical axis. The magnet 430 may overlap the OIS coil 420 in a direction perpendicular to the optical axis direction. The magnet 430 may be disposed between the AF coil 410 and the OIS coil 420.

The camera device 10A may comprise a guide part. The guide part may guide the movement of the moving part relative to the fixed part 100. The guide part may guide the movement of the moving part relative to the fixed part 100 in a specific direction. The guide part may comprise an AF guide part that guides the movement of the moving part relative to the fixed part 100 in the optical axis direction. The guide part may comprise an OIS guide part that guides the movement of the moving part relative to the fixed part 100 in a direction perpendicular to the optical axis.

The camera device 10A may comprise an upper elastic member 510. The guide part may comprise the upper elastic member 510. The upper elastic member 510 may be an AF spring. The upper elastic member 510 may be coupled to the housing 310 and the carrier 210. The upper elastic member 510 may be coupled to the housing 310. The upper elastic member 510 may be coupled to the carrier 210. The upper elastic member 510 may connect the housing 310 and the carrier 210. The upper elastic member 510 may elastically connect the housing 310 and the carrier 210. The upper elastic member 510 may support the carrier 210 to move in the optical axis direction with respect to the housing 310.

The upper elastic member 510 may comprise an inner portion 511 coupled to the carrier 210, an outer portion 512 coupled to the housing 310, and a connection part 513 connecting the inner portion 511 and the outer portion 512. The inner portion 511 may be coupled to the upper portion of the carrier 210. The inner portion 511 may be disposed on the upper surface of the carrier 210. The outer portion 512 can be coupled to the upper portion of the housing 310. The outer portion 512 can be disposed on the upper surface of the housing 310. The connection part 513 can comprise a plurality of bent parts. The connection part 513 can be elastic.

The camera device 10A may comprise a lower elastic member 520. The guide part may comprise the lower elastic member 520. The lower elastic member 520 may be a suspension spring. The lower elastic member 520 may be coupled to the housing 310 and the wire 530. The lower elastic member 520 may be coupled to the housing 310. The lower elastic member 520 may be coupled to the wire 530. The lower elastic member 520 may connect the housing 310 and the wire 530. The lower elastic member 520 may elastically connect the housing 310 and the wire 530.

The lower elastic member 520 may comprise a first coupling part 521 coupled to the housing 310, a second coupling part 522 coupled to the wire 530, and a connection part 523 connecting the first coupling part 521 and the second coupling part 522. The first coupling part 521 may be coupled to the lower portion of the housing 310. The first coupling part 521 may be disposed on the lower surface of the housing 310. The second coupling part 522 may be coupled to the lower end of the wire 530. The connection part 523 may comprise a plurality of bent parts. The connection part 523 may be elastic.

The camera device 10A may comprise a wire 530. The guide part may comprise the wire 530. The wire 530 can be coupled to the fixed part 100 and the lower elastic member 520. The wire 530 can be coupled to the fixed part 100. The wire 530 can be coupled to the lower elastic member 520. The wire 530 can connect the fixed part 100 and the lower elastic member 520. The wire 530 can elastically connect the fixed part 100 and the lower elastic member 520. The wire 530 can support the lower elastic member 520 to move in a direction perpendicular to the optical axis with respect to the fixed part 100. The wire 530 can be coupled to the upper cover 110. The wire 530 can be coupled to the substrate 111 of the upper cover 110. The wire 530 can be disposed parallel to the optical axis. The wire 530 may comprise a plurality of wires. The wire 530 may comprise four wires. The wire 530 may comprise first to fourth wires.

One end portion of the wire 530 may be coupled to the fixed part 100. The upper end portion of the wire 530 may be coupled to the fixed part 100. The other end portion of the wire 530 may be coupled to the lower elastic member 520. The lower end portion of the wire 530 may be coupled to the lower elastic member 520.

The camera device 10A may comprise an image sensor assembly 600. The image sensor assembly 600 may movably support the image sensor 630 and provide power to the image sensor 630.

The camera device 10A may comprise a sensor substrate 610. The image sensor assembly 600 may comprise the sensor substrate 610. The sensor substrate 610 may comprise a printed circuit board (PCB). The sensor substrate 610 may be a substrate or a circuit board. A sensor base 650 may be disposed on the sensor substrate 610. An image sensor 630 may be disposed on the sensor substrate 610. The sensor substrate 610 may comprise various circuits, elements, control parts, or the like to convert an image formed on the image sensor 630 into an electrical signal and transmit the electrical signal to an external device.

The sensor substrate 610 may be coupled to the lower surface of the sensor disposition part 641 of the support substrate 640. The sensor substrate 610 may comprise a hole. The hole may be hollow. An image sensor 630 may be disposed in a hole of the sensor substrate 610.

The camera device 10A may comprise a stiffener 620. The image sensor assembly 600 may comprise a stiffener 620. The stiffener 620 may be coupled to the sensor substrate 610. The stiffener 620 may be coupled to the lower surface of the sensor substrate 610. The stiffener 620 may be a reinforcing plate. The stiffener 620 may comprise a protrusion at a portion where the image sensor 630 is disposed.

The camera device 10A may comprise an image sensor 630. The image sensor assembly 600 may comprise the image sensor 630. The image sensor 630 can move integrally with the carrier 210. The image sensor 630 may be configured to form an image by incident light passing through a lens and a filter 660. The image sensor 630 may be disposed on a stiffener 620. The image sensor 630 may be disposed on an upper surface of the stiffener 620. The image sensor 630 may be coupled to the upper surface of the stiffener 620. The image sensor 630 may be disposed in a hole of a support substrate 640. The image sensor 630 may be mounted on a sensor substrate 610. The image sensor 630 may be electrically connected to the sensor substrate 610. The image sensor 630 may be coupled to the sensor substrate 610 using surface mounting technology (SMT). The image sensor 630 may be disposed so that optical axis thereof is aligned with that of the lens. In other words, the optical axis of the image sensor 630 and the optical axis of the lens may be aligned. The image sensor 630 may convert light irradiated onto the effective image area of the image sensor 630 into an electrical signal. The image sensor 630 may be any one of a charge-coupled device (CCD), a metal oxide semi-conductor (MOS), a CPD, and a CID.

The camera device 10A may comprise a support substrate 640. The image sensor assembly 600 may comprise a support substrate 640. The support substrate 640 may be electrically connected to the image sensor 630. The support substrate 640 can movably support the image sensor 630. The support substrate 640 can movably support the image sensor 630 in the optical axis direction. The support substrate 640 can movably support the image sensor 630 in a direction perpendicular to the optical axis. The support substrate 640 can movably support the image sensor 630 in both the optical axis direction and the direction perpendicular to the optical axis.

The support substrate 640 may comprise a sensor disposition part 641. An image sensor 630 may be disposed on the sensor disposition part 641. A sensor substrate 610 having the image sensor 630 disposed thereon may be disposed on the sensor disposition part 641. The image sensor 630 may be disposed on a stiffener 620, the stiffener 620 may be disposed on the sensor substrate 610, and the sensor substrate 610 may be disposed on the sensor disposition part 641.

The support substrate 640 may comprise a terminal part 642. The terminal part 642 may be disposed on the outside of the sensor disposition part 641. The terminal part 642 may comprise a terminal. The terminal may be connected to a power source external to the camera device 10A. Although the terminal part 642 is depicted as terminating inside the camera device 10A in the drawing, at least a portion of the terminal part 642 may pull outside the camera device 10A. The terminal part 642 may pull outside the camera device 10A and be connected to an external power source.

The support substrate 640 may comprise a connection part 643. The connection part 643 may comprise a sensor disposition part 641 and a terminal part 642. The connection part 643 may comprise a first portion disposed perpendicular to the optical axis. The connection part 643 may comprise a second portion disposed parallel to the optical axis.

The connection part 643 may comprise a shape that is bent a plurality of times. The sensor disposition part 641 can move in the optical axis direction and in the direction perpendicular to the optical axis with respect to the terminal part 642 due to the shape of the connection part 643 that is bent a plurality of times. The sensor disposition part 641 can move during AF operation and OIS operation. The terminal part 642 can be fixed without moving during AF operation and OIS operation. The connection part 643 can connect the sensor disposition part 641 and the terminal part 642 so that the sensor disposition part 641 can move with respect to the terminal part 642.

The connection part 643 can comprise a first bent part 643-1. The first bent part 643-1 can be bent about an virtual first bending axis. The first bending axis can be disposed parallel to the optical axis.

The connection part 643 may comprise a second bent part 643-2. The second bent part 643-2 may be bent about an virtual second bending axis. The second bending axis may be disposed perpendicular to the optical axis.

The camera device 10A may comprise a sensor base 650. The image sensor assembly 600 may comprise the sensor base 650. The sensor base 650 may be disposed on the sensor substrate 610. An opening may be formed in a portion of the sensor base 650 where the filter 660 is disposed so that light passing through the filter 660 may be incident on the image sensor 630.

The camera device 10A may comprise the filter 660. The image sensor assembly 600 may comprise the filter 660. The filter 660 may block light of a specific frequency band from passing through the lens module 700 from being incident on the image sensor 630. The filter 660 may be disposed perpendicular to the optical axis. The filter 660 may be disposed parallel to the x-y plane. The filter 660 may be disposed between the lens module 700 and the image sensor 630. The filter 660 may be disposed on the sensor base 650. The filter 660 may comprise an infrared filter. The infrared filter may block light in the infrared area from being incident on the image sensor 630.

The camera device 10A may comprise a motion sensor. The motion sensor may be mounted on the sensor substrate 610. The motion sensor may be electrically connected to a control part via a circuit pattern provided on the sensor substrate 610. The motion sensor may output rotational angular velocity information due to the movement of the camera device 10A. The motion sensor may comprise a two-axis or three-axis gyro sensor or an angular velocity sensor.

The camera device 10A may comprise a control part. The control part may be disposed on the sensor substrate 610. The control part may be electrically connected to the coils 410, 420. The control part may individually control the direction, intensity, and amplitude of the current supplied to the coils 410, 420. The control part may perform an autofocus function and/or an optical image stabilization function. Furthermore, the control part may perform autofocus feedback control and/or optical image stabilization feedback control.

The camera device 10A may comprise a lens module 700. The lens module 700 may comprise at least one lens. The lens may be disposed at a position corresponding to the image sensor 630. The lens module 700 may comprise a lens and a barrel. The lens module 700 may be coupled to a fixed part 100. The lens may be coupled to the fixed part 100. The lens may be fixed to the fixed part 100. The lens may be disposed on the fixed part 100. The lens may be adhered to the fixed part 100. The lens module 700 may be coupled to an upper cover 110. The lens may be coupled to the upper cover 110. The lens may be fixed to the upper cover 110. The lens may be disposed on the upper cover 110. The lens may be adhered to the upper cover 110.

Below, the configuration of a camera device according to a modified example is described with reference to drawings.

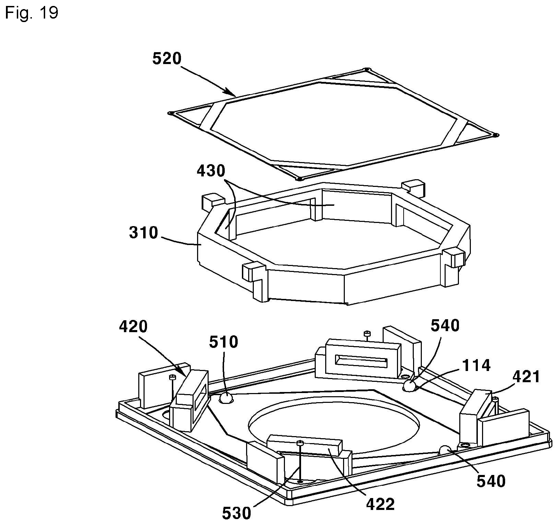

FIG. 18 is a cross-sectional view illustrating the disposition structure of a ball of a camera device according to a modified example. FIG. 19 is a bottom perspective view illustrating a ball and related components of a camera device according to a modified example.

The camera device 10A may comprise a ball 540. The guide part may comprise the ball 540. The ball 540 may be disposed between the upper cover 110 and the housing 310. The ball 540 may be disposed on the upper cover 110. The ball 540 may contact the upper cover 110. The ball 540 may be disposed directly on the upper cover 110. The ball 540 may be disposed on the housing 310. The ball 540 may contact the housing 310. The ball 540 may be disposed directly on the housing 310. The ball 540 may connect the upper cover 110 and the housing 310.

The ball 540 may be disposed in the groove 114 of the upper cover 110. At least a portion of the ball 540 may be accommodated in the groove 114 of the upper cover 110. The ball 540 may be disposed in the groove 312 of the housing 310. At least a portion of the ball 540 may be accommodated in the groove 312 of the housing 310. The ball 540 may be disposed between the groove 114 of the upper cover 110 and the groove 312 of the housing 310.

The ball 540 may guide the housing 310 to move in a direction perpendicular to the optical axis relative to the upper cover 110. The ball 540 may restrict the movement of the housing 310 relative to the upper cover 110 in a direction perpendicular to the optical axis.

Hereinafter, the auto focus (AF) operation and optical image stabilization (OIS) operation of the lens driving device according to the present embodiment will be described with reference to the drawings.

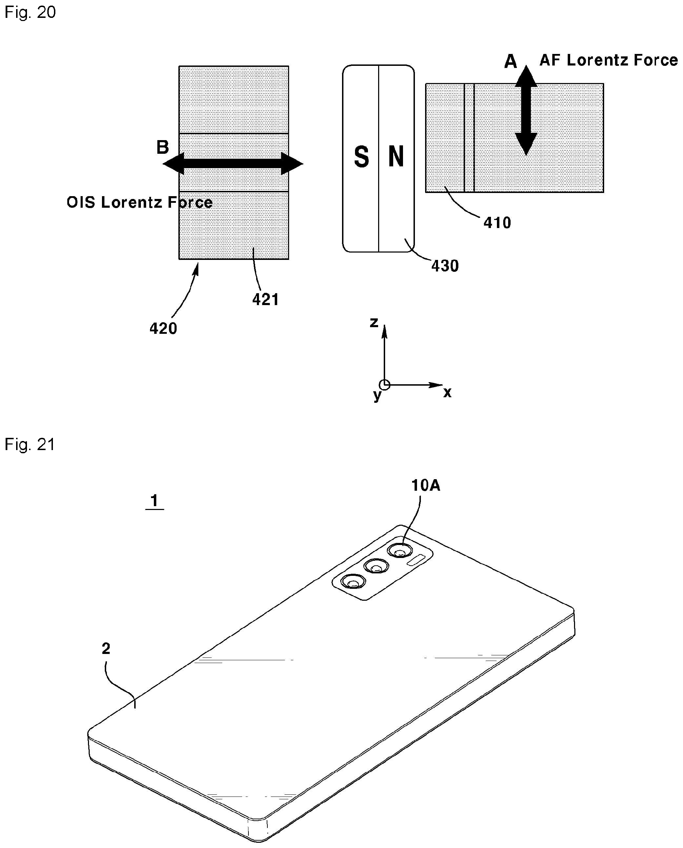

FIG. 20 is a diagram illustrating the operation of a camera device according to the present embodiment.

When current is applied to the AF coil 410, the AF coil 410 can move in the optical axis direction due to the electromagnetic interaction between the AF coil 410 and the magnet 430 (see A of FIG. 20). At this time, the carrier 210 and the image sensor 630 can move in the optical axis direction together with the AF coil 410. Accordingly, the distance between the lens and the image sensor 630 can be changed, so that the focus of the image formed on the image sensor 630 through the lens can be adjusted.

When current is applied to the OIS-x coil 421, the magnet 430 can move in the x-axis direction perpendicular to the optical axis due to the electromagnetic interaction between the OIS-x coil 421 and the magnet 430 (see B of FIG. 20). At this time, the housing 310, the carrier 210, and the image sensor 630 can move in the x-axis direction together with the magnet 430. Accordingly, when the user's hand tremors occur in the x-axis direction, the image sensor 630 can move in the x-axis direction relative to the lens to offset the user's hand tremors.

When current is applied to the OIS-y coil 422, the magnet 430 can move in the y-axis direction perpendicular to the optical axis due to the electromagnetic interaction between the OIS-y coil 422 and the magnet 430. At this time, the housing 310, the carrier 210, and the image sensor 630 can move in the y-axis direction together with the magnet 430. Accordingly, when the user's hand tremors occur in the y-axis direction, the image sensor 630 can move in the y-axis direction relative to the lens to offset the user's hand tremors.

Below, an optical device according to the present embodiment is described with reference to the drawings.

FIG. 21 is a perspective view illustrating an optical device according to the present embodiment.

The optical device 1 may comprise one or more of a mobile phone, a cellular phone, a portable terminal, a mobile terminal, a smart phone, a smart pad, a portable smart device, a digital camera, a laptop computer, a digital broadcasting terminal, a PDA (Personal Digital Assistant), a PMP (Portable Multimedia Player), and a navigation device. The optical device 1 may comprise any device for capturing videos or photographs.

The optical device 1 may comprise a main body 2. The optical device 1 may comprise a camera device 10A. The camera device 10A may be disposed on the main body 2. The camera device 10A may capture a subject. The optical device 1 may comprise a display. The display may be disposed on the main body 2. The display may output one or more of videos and images captured by the camera device 10A. The display may be disposed on a first surface of the main body 2. The camera device 10A may be disposed on at least one of the first side of the main body 2 and the second side opposite the first side. As illustrated in Fig. 21, the camera device 10A may have a triple camera disposed vertically. As a modified example, the camera device 10A may have a triple camera disposed horizontally.

Although the embodiments of the present disclosure have been described with reference to the attached drawings, those skilled in the art will appreciate that the present disclosure can be implemented in other specific forms without altering the technical concept or essential features thereof. Therefore, the embodiments described above should be understood to be illustrative in all respects and not restrictive.

## Claims

1. A camera device comprising:
a fixed part;
a housing movably disposed on the fixed part;
a carrier disposed in the housing;
a first coil configured to move the carrier in an optical axis direction;
a second coil configured to move the housing in a direction perpendicular to the optical axis direction;
a magnet configured to interact with at least one of the first coil and the second coil; and
an image sensor configured to move integrally with the carrier.

2. The camera device of claim 1, comprising a lens coupled to the fixed part,
wherein, when current is applied to the first coil, the lens is fixed and the image sensor moves in the optical axis direction.

3. The camera device of claim 2, wherein, when current is applied to the second coil, the lens is fixed and the image sensor moves in the direction perpendicular to the optical axis direction.

4. The camera device of claim 1, wherein the magnet overlaps with the first coil and the second coil in the direction perpendicular to the optical axis direction and is disposed between the first coil and the second coil.

5. The camera device of claim 1, comprising a first elastic member coupled to the housing and the carrier.

6. The camera device of claim 1, comprising:
a second elastic member coupled to the housing; and
a wire having one end portion coupled to the fixed part and the other end portion coupled to the second elastic member.

7. The camera device of claim 1, comprising a first substrate electrically connected to the image sensor and movably supporting the image sensor.

8. The camera device of claim 7, wherein the first substrate comprises a sensor disposition part, a terminal part disposed outside the sensor disposition part, and a connection part connecting the sensor disposition part and the terminal part, and
wherein the connection part comprises a shape that is bent a plurality of times.

9. The camera device of claim 8, wherein the connection part comprises a first bent part that is bent about an virtual first bending axis, and a second bent part that is bent about an virtual second bending axis,
wherein the first bending axis is disposed parallel to an optical axis, and
wherein the second bending axis is disposed perpendicular to the optical axis.

10. The camera device of claim 8, comprising:
a second substrate coupled to a lower surface of the sensor disposition part of the first substrate and comprising a hole; and
a stiffener coupled to a lower surface of the second substrate,
wherein the image sensor is coupled to an upper surface of the stiffener and disposed on the hole of the first substrate.
